Europäisches Patentamt

European Patent Office

Office européen des brevets

(11) Veröffentlichungsnummer: **0 284 546 B1**

(12) **EUROPÄISCHE PATENTSCHRIFT**

(45) Veröffentlichungstag der Patentschrift: **26.08.92**

(51) Int. Cl.⁵: **H02H 3/38**, G01R 31/08, G01R 27/14

(21) Anmeldenummer: **88730054.9**

(22) Anmeldetag: **03.03.88**

(54) **Verfahren zur Prüfung von Anordnungen.**

(30) Priorität: **23.03.87 DE 3709532**

(43) Veröffentlichungstag der Anmeldung:
**28.09.88 Patentblatt 88/39**

(45) Bekanntmachung des Hinweises auf die
Patenterteilung:
**26.08.92 Patentblatt 92/35**

(84) Benannte Vertragsstaaten:
**CH DE GB LI SE**

(56) Entgegenhaltungen:
**GB-A- 2 016 833**
**GB-A- 2 116 792**

**IEE PROCEEDINGS, Section A-I, Band 130,
Nr. 3, Teil C, Mai 1983, Seiten 127-138; A.T.
JOHNS et al.: "New ultra-high-speed distance protection using finite-transform techniques"**

(73) Patentinhaber: **SIEMENS AKTIENGESELL-
SCHAFT
Wittelsbacherplatz 2
W-8000 München 2(DE)**

(72) Erfinder: **Sezi, Tevfik, Dr.
Lauenburger Strasse 106
W-1000 Berlin 41(DE)**
Erfinder: **Metzger, Klaus, Dr.
Suchlandstrasse 9
W-1000 Berlin 41(DE)**

**Beschreibung**

Die Erfindung bezieht sich auf ein Verfahren zur Prüfung von Anordnungen, deren Betriebsverhalten durch lineare zeitinvariante Differentialgleichungen erster Ordnung beschreibbar ist, bei dem

- die Ausgangsgrößen der jeweils zu prüfenden Anordnung während einer entsprechenden Eingangserregung der Anordnung gemessen werden,
- die gemessenen Ausgangsgrößen der zu prüfenden Anordnung in einer Filtereinheit mit Einzelfiltern eines ersten und eines zweiten Typs derart mit den zwei Filtertypen bewertet werden, daß an den Ausgängen der Einzelfilter Signale entstehen, die durch die Bewertung der Ausgangsgrößen mittels Einzelfilter des ersten Typs und durch die Bewertung mindestens einer der Ausgangsgrößen mittels Einzelfilter des zweiten Typs gebildet sind, wobei die Bewertung mittels des Einzelfilters des zweiten Typs der ersten zeitlichen Ableitung der Ausgangsgröße entspricht,
- die in den Differentialgleichungen vorkommenden Parameter der Anordnung aus den bewerteten Ausgangsgrößen in einer Recheneinheit ermittelt werden und
- bei der Bewertung entstandene Fehler durch eine Fehlerkorrektur berücksichtigt werden.

Ein derartiges Verfahren zur Prüfung von linearen zeitinvarianten Anordnungen mittels Parameteridentifikation ist bekannt aus der Dissertation von Dr. K. Metzger mit dem Titel "Eine Methode zur Prüfung von Kleinmotoren unter Einsatz eines Parameterschätzverfahrens" aus dem Jahre 1983.

Ziel des bekannten Verfahrens ist es, die Parameter einer Anordnung, d. h. die anordnungsimmanenten Größen, einzig aus der Kenntnis der direkt meßbaren Ausgangsgrößen der Anordnung zu ermitteln. Aus den ermittelten Parametern kann dann durch Vergleich mit vorgegebenen Sollparametern auf die Funktionsfähigkeit und Güte der zu prüfenden Anordnung geschlossen werden. Vorteil eines solchen Verfahrens ist die Umgehung aufwendiger Belastungs- und Prüfeinrichtungen zur Ermittlung der Parameter.

Das bekannte Verfahren geht davon aus, daß ein Zusammenhang zwischen den Parametern einer Anordnung und seinen Ausgangsgrößen die Differentialgleichungen liefern, welche das Betriebsverhalten des Systems beschreiben. Aus diesen könnten durch Messen der Ausgangsgrößen und Bildung ihrer zeitlichen Ableitungen die Parameter errechnet werden. Problem bei dieser Ermittlung ist, daß aus den Ausgangsgrößen abgeleitete Meßgrößen verwendet werden müssen. Deren Ableitung verursacht einen erheblichen Rechen- und Zeitaufwand. Dieser Aufwand wird bei dem bekannten Verfahren vermieden, indem die meßbaren Ausgangsgrößen in einer geeigneten analogen Filtereinheit bewertet werden. Die Bewertung von nach der Zeit abzuleitenden Größen mit der Gewichtsfunktion eines Filters kann nämlich auf die Bewertung der unabgeleiteten Größe mit der abgeleiteten Gewichtsfunktion des Filters zurückgeführt werden.

Es wird dazu eine Filtereinheit benötigt, die aus Filtern zweier Typen besteht, von denen der zweite Filtertyp als Gewichtsfunktion die Ableitung der Gewichtsfunktion des ersten Filtertyps aufweist. Eine so beschriebene Gewichtsfunktion und deren abgeleitete Gewichtsfunktion können durch einfaches Integrieren erzeugt werden. Die Realisierung der analogen Filter erfolgt dementsprechend durch einfache Integrierer.

Durch die Verwendung von elektronischen Komponenten bei dem bekannten Verfahren, insbesondere durch den Einsatz von Integrierern, fließt ein systematischer Fehler in die Ermittlung der Parameter ein, der mittels einer relativ umfangreichen Fehlerbetrachtung kompensiert werden muß.

Eine genaue Filterkalibrierung ist erforderlich, um Fehler durch Kettenbildung der einzelnen Integrationsfaktoren bei Mehrfachintegrationen zu vermeiden. Die Genauigkeit des bekannten Verfahrens mit einer Bewertung der Ausgangsgrößen durch analoge Filter ist also nur unter Einsatz von qualitativ hochwertigen analogen Bauelementen in Verbindung mit einer umfangreichen und aufwendigen Fehlerbetrachtung in dem erforderlichen Rahmen zu erzielen. Hierzu sind hohe Rechenzeiten erforderlich. Weiterhin ist es bei Verwendung von analogen Filtern nicht möglich, gezielt beliebige Einzelfrequenzen aus der Filterübertragungsfunktion zu eliminieren. In den Frequenzgängen analoger Filter stehen nämlich eliminierbare Frequenzen in einem unveränderlichen Zusammenhang zueinander.

Bei einem Verfahren der eingangs angegebenen Art ist erfindungsgemäß vorgesehen, daß

- die gemessenen Ausgangsgrößen digitalisiert und in einer digitalen Filtereinheit bewertet werden, die aus einer entsprechenden Anzahl von linearphasigen, nicht rekursiven Digitalfiltern (FIR-Filter) eines ersten Typs (mit den Gewichtsfaktoren $h_i$) und aus mindestens einem Digitalfilter eines zweiten Typs (mit den Gewichtsfaktoren $g_i$) besteht,
- die einzelnen Gewichtsfaktoren der FIR-Filter ($h_i$, $g_i$) frei vorgegeben werden und
- die Fehlerkorrektur mittels eines Korrekturfaktors $k_c$ durchgeführt wird, der als Quotient aus den Amplitudengängen ($H(\Omega)$, $G(\Omega)$) der FIR-Filter ersten und zweiten Typs gebildet wird.

Bei der Durchführung des erfindungsgemäßen Verfahrens kann der Korrekturfaktor $k_c$ als Quotient aus dem Amplitudengang des FIR-Filters ersten Typs zu dem des FIR-Filters zweiten Typs gewonnen werden, sofern die gemessenen Ausgangsgrößen entsprechend bewertet werden. Besonders vorteilhaft ist es, zur Gewinnung des Korrekturfaktors $k_c$ den Quotienten aus dem Amplitudengang G ($\Omega$) des FIR-Filters zweiten Typs zum Amplitudengang H ($\Omega$) des FIR-Filters ersten Typs zu bilden.

Der Einsatz digitaler Filter bei dem erfindungsgemäßen Verfahren zur Prüfung von Anordnungen bedeutet eine erhebliche Verbesserung hinsichtlich der Genauigkeit des Verfahrens. Weiterhin können durch Wahl entsprechend schneller Rechner die Rechenzeiten erheblich verringert werden. Außerdem können Anforderungen erfüllt werden, deren Realisierung mit den analogen Filtern nicht möglich ist. Ein Beispiel hierfür ist die gezielte Eliminierung ausgewählter Frequenzen im Erregersignal, die aber auch je nach Erfordernis (abhängig von der beschreibenden Differentialgleichung) zur Ermittlung der Parameter mit gewählter Einflußstärke (Amplitude) herangezogen werden können. Durch den Einsatz der digitalen Filter werden die Filterübertragungsfunktionen je nach den erforderlichen Einsatzbedingungen gewählt. Eine Abhängigkeit von den bei analogen Filtern nur in geringem Maße beeinflußbaren Übertragungsfunktionen besteht nicht. Die Verwendung der FIR-Filter bei dem erfindungsgemäßen Verfahren garantiert, daß die erforderlichen Filtereigenschaften vorhanden sind. Die Verwendung solcher Filter ermöglicht zudem noch eine äußerst einfache Fehlerkorrektur, die darüber hinaus einfach in den Verfahrensablauf integrierbar ist.

Aufgrund der großen Variabilität des erfindungsgemäßen Verfahrens können beliebige Anordnungen, die durch lineare, zeitinvariante Differentialgleichungen erster Ordnung beschrieben werden, mit dem erfindungsgemäßen Verfahren geprüft werden. Die Prüfung von beispielsweise entsprechenden Haushaltsgeräten ist ebenso möglich wie die Prüfung von beispielsweise Hochspannungsübertragungsleitungen, wobei bei letzteren das erfindungsgemäße Verfahren besonders wirkungsvoll als Distanzschutz und Fehlerorter eingesetzt werden kann. Anordnungen, deren Ausgangsgrößen nichtelektrische Signale sind, können nach deren entsprechender Wandlung ebenfalls geprüft werden.

Möglich ist auch die Erweiterung des erfindungsgemäßen Verfahrens auf Anordnungen beliebiger Ordnung; hierfür sind die digitalen FIR-Filter allerdings nach allgemeinen Gesichtspunkten zu realisieren, so daß die erforderliche Fehlerkorrektur umfangreicher wird.

Mit dem erfindungsgemäßen Verfahren lassen sich durch lineare Differentialgleichungen beschreibbare Anordnungen nur innerhalb bestimmter Frequenzbänder mit vorgegebener Breite genau überprüfen (Shannon-Theorem). Nichtlinearitäten führen schnell Frequenzen außerhalb der Frequenzbänder. Führen jedoch auftretende Nichtlinearitäten zu sehr hohen Frequenzen, so können durchaus auch solche Anordnungen mit dem erfindungsgemäßen Verfahren geprüft werden, da dann nur noch ein sehr kleiner Fehler gemacht wird.

Die Voraussetzung einer Quasi-Zeitinvarianz zumindest für den Zeitraum einer Messung ist erforderlich, um die Reproduzierbarkeit der Verfahrensergebnisse gewährleisten zu können.

Gemäß einer Ausgestaltung des erfindungsgemäßen Verfahrens ist es vorteilhaft, wenn die Filtereinheit und die Fehlerkorrektur in der Recheneinheit realisiert werden. Die Recheneinheit wird benötigt, um die Ausgangssignale der FIR-Filter zur Ermittlung der Parameter abzuarbeiten. Das ganze erfindungsgemäße Verfahren kann dann in einem einzigen Rechner durchgeführt werden. Hierbei ist es günstig, wenn auch die erforderlichen Analog-Digital-Umsetzer in den Rechner integriert sind.

Weiterhin ist es vorteilhaft, wenn das FIR-Filter ersten Typs durch ein symmetrisches Zählerpolynom (Gewichtsfaktorenverteilung $h_i = h_{n-i}$) mit geradem Zählergrad n und das FIR-Filter zweiten Typs durch ein antisymmetrisches Zählerpolynom (Gewichtsfaktorenverteilung $g_i = -g_{n-i}$) mit geradem Zählergrad n beschrieben wird. Bei der Kombination von FIR-Filtern mehrerer Typen ist es nur möglich, solche mit gleichem Zählergrad n zu kombinieren, da ansonsten die Filter unterschiedliche Verzögerungen erzeugen würden. Der Zählergrad n kann beliebig als gerade oder ungerade Zahl gewählt werden; wird er als gerade Zahl gewählt, wird die durch das Filter bewirkte Phasendrehung, für die der Zählergrad n/2 der ausschlaggebende Faktor ist, mit einer ganzen Zahl multipliziert.

Nach einer weiteren Ausgestaltung des erfindungsgemäßen Verfahrens ist es besonders vorteilhaft, wenn

   - die Gewichtsfaktoren $h_i$ des FIR-Filters ersten Typs mit der Verteilung $h_i = h_{n-i}$ mit geradem Zählergrad n in der Form

$$h_0 = h_n = 0$$
$$h_1 = h_{n-1} = 1$$
$$h_2 = h_{n-2} = 2$$
$$\ldots$$
$$h_{n/2-1} = h_{n/2+1} = n/2 - 1 \text{ vorgegeben werden und}$$

- die Gewichtsfaktoren $g_i$ des FIR-Filters zweiten Typs mit der Verteilung $g_i = -g_{n-i}$ mit geradem Zählergrad n in der Form

$$g_0 = -g_n = 1/2$$
$$g_1 = -g_{n-1} = 1$$
$$g_2 = -g_{n-2} = 1$$
$$\ldots$$
$$g_{n/2-1} = -g_{n/2+1} = 1 \text{ vorgegeben werden.}$$

Hierbei werden nämlich die abgetasteten und digitalisierten Werte der Ausgangsgrößen der Anordnung, die ja mit den Gewichtsfaktoren der einzelnen Filter bewertet werden, lediglich mit einfachen, zumeist ganzen Zahlen multipliziert, was rechnerisch einen geringen Aufwand bedeutet. Weiterhin ist ein Algorithmus, aus dem die Gewichtsfaktoren rechnerisch zu gegebenenfalls sehr kleinen, ungeraden Zahlen ermittelt werden, nicht vorhanden, da diese einfach fest vorgegeben werden. Bei einer derartigen Wahl der Gewichtsfaktoren ergibt sich dann als besonderer Vorteil, daß der Korrekturfaktor eine konstante Größe ist, der unabhängig von dem gewählten Zählergrad n für die Filterrealisierung eine Konstante ist.

Wenn wie nach einer weiteren Ausgestaltung des erfindungsgemäßen Verfahrens die zu überprüfende Anordnung eine elektrische Hochspannungsübertragungsleitung ist, wird vorteilhafterweise der Zählergrad n zur Distanzmessung mit n = 8 gewählt und zur Fehlerortsbestimmung mit n = 14. Das bedeutet, daß der Zählergrad n je nach der erforderlichen Meßaufgabe beliebig gewählt und variiert werden kann, um so jeweils das Optimum aus Ermittlungsschnelligkeit und Genauigkeit für die bei einer Hochspannungsübertragungsleitung relevanten Parameter (Impedanz bzw. Induktivität und ohmscher Widerstand) mit dem eingesetzten Verfahren zu erhalten. Für die Berechnung der Parameter ist es dabei vorteilhaft, wenn deren Ermittlung im zeitlichen Abstand von ungefähr 1/4 Netzperiodendauer erfolgt. Es ist so gewährleistet, daß die entsprechend abgetasteten Ausgangsgrößen der Hochspannungsübertragungsleitung als zu prüfender Anordnung linear unabhängig voneinander sind, so daß Genauigkeit und Reproduzierbarkeit der Parameterermittlung hoch sind. Außerdem wird so der erforderliche Rechenaufwand bei guter Kontrolle der Hochspannungsübertragungsleitung in einem vertretbaren Rahmen gehalten.

Der genaue Ablauf des erfindungsgemäßen Verfahrens, seine mathematische Beschreibung und die Durchführung des Verfahrens als Anwendungsbeispiel für eine Hochspannungsübertragungsleitung ist den Figuren 1 bis 4 zu entnehmen.

Fig. 1A zeigt eine schematisierte Darstellung der zu prüfenden Hochspannungsübertragungsleitung.

Fig. 1B zeigt die Darstellung der das Verhalten der Hochspannungsübertragungsleitungbeschreibenden normierten Differentialgleichung in einem Blockschaltbild.

Fig. 2 zeigt das Prinzip des Verfahrens in einem Blockschaltbild.

Fig. 3 zeigt den normierten Amplitudengang und Gewichtsfaktoren erfindungsgemäß realisierter FIR-Filter mit einem Zählergrad n = 8.

Fig. 4 zeigt den normierten Amplitudengang und die Gewichtsfaktoren erfindungsgemäß realisierter FIR-Filter mit einem Zählergrad n = 14.

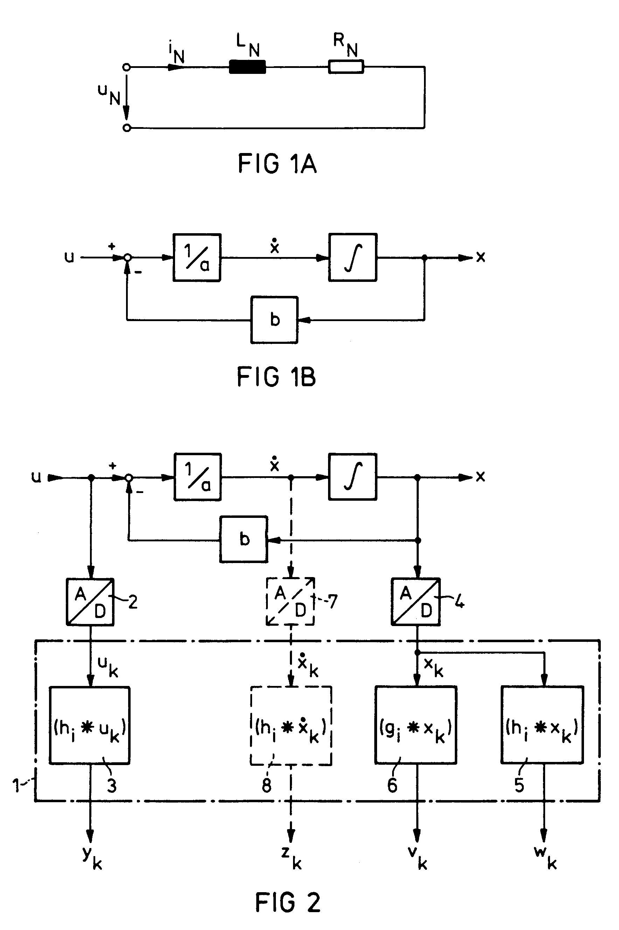

Das in der Figur 1A dargestellte Schema einer elektrischen Hochspannungsübertragungsleitung weist eine Netzinduktivität $L_N$ und einen ohmschen Netzwiderstand $R_N$ auf. Sie wird durchflossen von einem Netzstrom $i_N$ ; an den Klemmen des Hochspannungsnetzes ist eine Netzspannung $u_N$ abgreifbar. Die Größen $i_N$ und $u_N$ stellen die Ausgangsgrößen der Hochspannungsübertragungsleitung als zu prüfender Anordnung dar. Die diese Anordnung beschreibende Differentialgleichung lautet:

$$u_N = L_N \cdot \frac{di_N}{dt} + R_N \cdot i_N \qquad\qquad (1)$$

Um Gleichung (1) in eine von Absolutwerten unabhängige Darstellung zu überführen, wird eine Zeit- und Amplitudennormierung durchgeführt.

Es gilt:

$$x = \frac{i_N}{I_{Nm}}$$

x : normierter Netzstrom

$i_N$ : Netzstrom

$I_{Nm}$ : Normierungswert von $i_N$

$$u = \frac{u_N}{U_{Nm}}$$

u : normierte Netzspannung

$u_N$ : Netzspannung

$U_{Nm}$ : Normierungswert von $u_N$

$$a = \frac{T_A}{\Omega_N} \cdot X_N{}'$$

a : normierte Netzimpedanz

$\Omega_N$ : normierte Netzfrequenz

$T_A$ : Normierung- bzw. Abtastzeit

$$\Omega_N = \omega_N \cdot T_A$$

$\omega_N$ : Netzfrequenz

$$X_N{}' = \frac{X_N}{R_0}$$

$X_N$ : Netzimpedanz von $L_N$

$$X_N = \omega_N L_N$$

$L_N$ : Netzinduktivität

$$R_0 = \frac{U_{Nm}}{I_{Nm}}$$

$R_0$ : Normierungswiderstand

$$b = R_N{}'$$

b : normierter Netzwiderstand

$$R_N{}' = \frac{R_N}{R_0}$$

$R_N$ : Netzwiderstand

Die solchermaßen normierte und umgestellte Differentialgleichung (1) lautet nun

$$a \cdot \dot{x} = - bx + u. \qquad (2)$$

Das Blockschaltbild zu der normierten Differentialgleichung (2) ist der Figur 1B zu entnehmen. Aus der Gleichung (2) könnten die normierten Parameter a und b, die nun an die Stelle der absoluten Parameter $L_N$ und $R_N$ getreten sind, durch Messung der Größen u, x und $\dot{x}$ zu zwei unterschiedlichen Zeitpunkten $t_1$ und $t_2$ bestimmt werden. Voraussetzung dafür ist, daß sich die Anordnung zu den Zeitpunkten $t_1$ und $t_2$ in zwei voneinander unabhängigen Zuständen befindet.

In Fig. 2 ist das Prinzip des erfindungsgemäßen Verfahrens in Form eines Blockschaltbildes dargestellt. Da es die dem Verfahren zugrunde liegende Aufgabe ist, die Parameter a und b ohne Bildung der ersten zeitlichen Ableitung des normierten Stromes $\dot{x}$ zu ermitteln, werden die normierten Ausgangsgrößen u und x in einer Filtereinheit 1 bewertet. Eine solche Bewertung erfolgt durch Faltungsoperationen (symbolisch mit *
im Blockschaltbild dargestellt). Die normierte Ausgangsgröße u wird dazu über einen Analog-Digital-
Umsetzer 2, der die Ausgangsgröße u nach Abtastung mit einer entsprechend gewählten Abtastzeit $T_A$ in
eine Zahlenfolge $u_k$ umsetzt, einem digitalen FIR-Filter 3 zugeführt. Dieses digitale FIR-Filter 3 gehört zu
einem ersten Filtertyp und weist eine symmetrische Gewichtsfaktorenverteilung $h_i = h_{n-i}$ auf. An dem
Ausgang des digitalen FIR-Filters 3 entsteht eine Folge $y_k$, deren Abbildungsvorschrift lautet:

$$y_k = \sum_{i=0}^{n} h_i \cdot u_{k-i} \qquad (3)$$

Weiterhin wird nach entsprechender Abtastung in einem weiteren Analog-Digital-Umsetzer 4 die
normierte Ausgangsgröße x umgesetzt und die entstandenen Werte $x_k$ einem digitalen FIR-Filter 5
zugeführt, der ebenfalls zum ersten Filtertyp gehört und dessen Gewichtsfaktorenverteilung identisch ist mit
der des digitalen FIR-Filters 3; an dessen Ausgang wird eine Folge $w_k$ erzeugt, die beschrieben ist mit:

$$w_k = \sum_{i=0}^{n} h_i \cdot x_{k-i} \qquad (3a)$$

Außerdem werden die abgetasteten Werte $x_k$ einem digitalen FIR-Filter 6 zugeführt, der einem zweiten Typ
angehört, dessen Gewichtsfaktorenverteilung lautet:
$g_i = - g_{n-i}$.
Am Ausgang dieses digitalen FIR-Filters 6 entsteht eine Folge $v_k$, deren Abbildungsvorschrift lautet:

$$v_k = \sum_{i=0}^{n} g_i \cdot x_{k-i} \qquad (3b)$$

Eine Abtastung der Größe $\dot{x}$, deren Umsetzung in einem zusätzlichen Analog-Digital-Umsetzer 7 und
Bewertung in einem zusätzlichen digitalen FIR-Filter 8, unter Bildung einer zusätzlichen Ausgangsfolge $z_k$
ist wie bei dem bekannten Verfahren auch hier nicht erforderlich, daß es möglich ist, die Gewichtsfaktoren
$h_i$ und $g_i$ der FIR-Filter 3 bzw. 5 und 6 so zu bestimmen, daß die Folge $v_k$ identisch ist mit der zusätzlichen
Folge $z_k$, deren - tatsächlich nicht erfolgende - Bildung in der Figur 2 strichliert angedeutet ist.
Die durch die FIR-Filter 3, 5 und 6 erzeugten Ausgangsfolgen $y_k$, $v_k$ und $w_k$ werden so miteinander
verknüpft, daß sie der aus der normierten Differentialgleichung (1) abgeleiteten Differentialgleichung (4)
genügen:

$$y_k = a \cdot v_k + b \cdot w_k \qquad (4)$$

Es handelt sich bei Gleichung (4) um eine von Ableitungen der Ausgangsgröße x freie lineare Gleichung
mit zwei Unbekannten, nämlich den Parametern a und b, welche durch Ermitteln, Bewerten und Einsetzen
von jeweils zwei linear voneinander unabhängigen Abtastwerten von u und x lösbar ist.
Wie oben bemerkt, ist eine Umgehung der Ableitung der Ausgangsgröße x möglich, weil die Gewichtsfaktoren $h_i$ und $g_i$ so bestimmt werden können, daß die Ausgangsfolge $v_k$ identisch ist mit der Ausgangsfolge $z_k$. Es ist also notwendig, FIR-Filter zu realisieren, die diese Bedingung - zumindest in einem
bestimmten Frequenzbereich - einhalten. Für die Ermittlung der Gewichtsfaktoren von passenden FIR-
Filtern ist vorauszusetzen, daß die FIR-Filter mit den Abtastwerten einer sinusförmigen Funktionangeregt
werden. Im vorliegenden Falle ist die Funktion x (t) die Erregerfunktion und wird in Form einer digitalen
Funktionsfolge beschrieben:

$x_k = \sin (\Omega \cdot k + \phi)$ bzw. $\qquad (5a)$
$\dot{x}_k = \Omega \cos (\Omega \cdot k + \phi) \qquad (5b)$

Der Faktor k ist eine ganze Zahl und die Laufvariable des Funktionswertes $x_k$. Eine Phasenverschiebung $\phi$ soll im vorliegenden Fall nicht berücksichtigt werden. $\Omega$ ist die normierte Frequenz.

Für FIR-Filter ist die Berechnung des Amplitudenganges allgemein bekannt und lautet für FIR-Filter mit symmetrischem Zählerpolynom und geradem Zählergrad n:

$$H(\Omega) = h_{n/2} + \sum_{i=0}^{n/2-1} 2 h_i \cdot \cos\left[(n/2 - i)\Omega\right] \tag{6a}$$

Die komplexe Übertragungsfunktion dieses FIR-Filters lautet damit:

$$H(j\Omega) = H(\Omega) \cdot e^{-j\Omega \cdot n/2} \tag{6b}$$

Für FIR-Filter mit antisymmetrischem Zählerpolynom und geradem Zählergrad n berechnet der Amplitudengang sich zu:

$$G(\Omega) = \sum_{i=0}^{n/2-1} 2 g_i \cdot \sin\left[(n/2 - i)\Omega\right] \tag{6c}$$

Für dieses FIR-Filter lautet die komplexe Übertragungsfunktion:

$$G(j\Omega) = j G(\Omega) \cdot e^{-j\Omega \, n/2} \tag{6d}$$

In den Gleichungen (6b) und (6d) bezeichnet der Exponentialausdruck den Phasengang der jeweiligen Übertragungsfunktion. Der Phasengang ist für die FIR-Filter beider Typen identisch und linear. Der Faktor n/2 im Phasengang deutet darauf hin, daß die Filter eine Phasenverzögerung um n/2 bewirken. Der Faktor j in Gleichung (6d) bedeutet eine zusätzlich erfolgende Drehung der Phase um + 90° bei einer Bewertung mit einem FIR-Filter zweiten Typs.

Für die Folge $v_k$ ergibt sich aus den Gleichungen (5a), (6c) und (6d):

$$v_k = G(\Omega) \cdot \cos\left[\Omega(k - n/2) + \phi\right] \tag{7a}$$

und für die Folge $z_k$ entsprechend aus den Gleichungen (5b), (6a) und (6b):

$$z_k = H(\Omega)\, \Omega \cos\left[\Omega(k - n/2) + \phi\right] \tag{7b}$$

Aufgrund der geforderten Bedingung $v_k = z_k$ ergibt sich damit aus den Gleichungen (7a), (7b) die Filterbedingung für digitale FIR-Filter:

$$G(\Omega) = \Omega H(\Omega) \tag{8a}$$

und entsprechend für die Übertragungsfunktionen:

$$G(j\Omega) = j \Omega H(j\Omega) \tag{8b}$$

Die Gewichtsfaktoren $h_i$ und $g_i$ der digitalen FIR-Filter müssen entsprechend gewählt werden.

An dieser Stelle ist zu bemerken, daß für Anordnungen n-ter Ordnung die Filterbedingung ähnlich lautet:

$$G(j\Omega) = j \Omega^n \cdot H(j\Omega) \tag{8c}$$

Eine Filterrealisierung ist dann unter Einhaltung dieser Filterbedingung (8c) durchzuführen.

Die Realisierung der gesuchten FIR-Filter erfolgt erfindungsgemäß durch eine direkte Vorgabe erwünschter Gewichtsfaktoren. Mit einer derartigen Vorgabe kann erreicht werden, daß speziell im Bereich der interessierenden Netzfrequenz die FIR-Filter ein optimales Übertragungsverhalten aufweisen, wohingegen

7

EP 0 284 546 B1

Oberfrequenzen gedämpft oder eliminiert werden können. Wenn also das Erregersignal keine Oberfrequenzen aufweist oder diese durch FIR-Filter entsprechend gedämpft werden, genügt es, wenn die Filterbedingung auch nur für die Netzfrequenz erfüllt wird. Dabei ist vorausgesetzt, daß die Netzfrequenz konstant ist.

Bei einer solchen freien Vorgabe der Gewichtsfaktoren der FIR-Filter ist es allerdings möglich, daß die Filterbedingung auch für die Netzfrequenz nicht erfüllt wird. Hierzu muß, nachdem mit den vorgegebenen Gewichtsfaktoren die Berechnung der Parameter durchgeführt worden ist, eine Fehlerkorrektur der Parameter erfolgen. Eine derartige Fehlerkorrektur ist allerdings nur dann sinnvoll, wenn es sich um ein System erster Ordnung handelt, bei dem zur Bestimmung nur eine Erregerfrequenz, nämlich die Netzfrequenz, benötigt wird. Bei Anordnungen höherer Ordnung ist eine derartige einfache Fehlerkorrektur nicht möglich.

Zusammenfassend gesagt geht man bei der Realisierung der gesuchten FIR-Filter folgendermaßen vor:

1. Vorgabe der erwünschten Gewichtsfaktoren $h_i$, $g_i$
2. Berechnung der Amplitudengänge der FIR-Filter beider Typen $H(\Omega)$, $G(\Omega)$
3. Einführung von korrigierten Gewichtsfaktoren mit

$$h_{ci} = h_i \qquad h_{ci} = \text{korrigierter Gewichtsfaktor erster Filtertyp} \qquad (9a)$$

$$g_{ci} = \frac{\Omega_N}{k_c} \cdot g_i \qquad g_{ci} = \text{korrigierter Gewichtsfaktor zweiter Filtertyp} \qquad (9b)$$

$$k_c = \text{Korrekturfaktor}$$

Da der Fehler aufgrund vorgewählter Gewichtsfaktoren und damit nicht berücksichtigter Oberfrequenzen im vorliegenden Falle nur in die Berechnung der Impedanz eingeht und diese nur über die Bewertung mit den Gewichtsfaktoren $g_i$ des zweiten Filtertyps erfolgt, müssen folglich auch nur diese korrigiert werden.

Mit den korrigierten Gewichtsfaktoren $h_{ci}$, $g_{ci}$ ergeben sich die korrigierten Amplitudengänge zu

$$H_c(\Omega) = H(\Omega) \qquad (9c)$$
$$G_c(\Omega) = (\Omega_N/k_c)\, G(\Omega) \qquad (9d)$$

Gemäß Voraussetzung müssen diese korrigierten Amplitudengänge $H_c$, $G_c$ die Filterbedingung nur bei der Netzfrequenz, d. h. bei $\Omega = \Omega_N$ erfüllen. Daraus folgt unter Berücksichtigung der Gleichungen (8a), (9c), (9d) für den Korrekturfaktor $k_c$:

$$k_c = \frac{G(\Omega_N)}{H(\Omega_N)} \qquad (10)$$

Mit den gemachten Voraussetzungen wird bei der Realisierung der erforderlichen FIR-Filter eine einfache Korrekturmöglichkeit geschaffen, mit Hilfe derer man einerseits die Gewichtsfaktoren so vorgeben kann, daß sie einfach zu realisieren und zu verarbeiten sind, andererseits kann man aber auch eine genaue Übereinstimmung der realisierten Filterfunktion mit der idealen Filterfunktion, die für jede Frequenz die Filterbedingung erfüllt, im Bereich der interessierenden Frequenz, nämlich im Bereich der Netzfrequenz erreichen.

Die Bestimmungsgleichungen für die korrigierten Gewichtsfaktoren an zwei Abtaststellen k und m, aufgelöst nach den gesuchten Parametern a und b lauten dann folgendermaßen:

$$a_c = \frac{(h_i * u_k)(h_i * x_m) - (h_i * u_m)(h_i * x_k)}{(\Omega_N/k_c)(g_i * x_k)(h_i * x_m) - (\Omega_N/k_c)(g_i * x_m)(h_i * x_k)} \qquad (11)$$

$$b_c = -\frac{(h_i * u_k)(g_i * x_m) - (h_i * u_m)(g_i * x_k)}{(g_i * x_k)(h_i * x_m) - (g_i * x_m)(h_i * x_k)} \qquad (12)$$

Daraus können dann anhand der zu Gleichung (1) gemachten Normierungen die Netzinduktivität $L_N$ und der Netzwiderstand $R_N$ ermittelt werden.

Für die Realisierung der gesuchten Filter durch Vorgabe gewünschter Gewichtsfaktoren sind mehrere Integrationsverfahren bekannt. Es handelt sich hierbei beispielsweise um die A4-Methode und um die Simpson-Methode. Für beide gilt jedoch, daß diese die Gewichtsfaktoren erstellen, ohne die Filterbedingung zu berücksichtigen. Dadurch entsteht für sinusförmige Erregungsgrößen bei der Netzfrequenz $\Omega_N$ ein Amplitudenfehler, der allerdings mit dem im Vorangehenden hergeleiteten Korrekturfaktor relativ einfach in Abhängigkeit von der Anzahl der Gewichtsfaktoren kompensiert werden kann, die Berechnung dieses Korrekturfaktors erfordert jedoch mit steigendem Zählergrad n (Anzahl der Gewichtsfaktoren) einen stark ansteigenden Rechenaufwand. Weiterhin wird bei den konventionellen Verfahren die Ableitung der Ausgangsgröße x ersetzt durch zwei Abtastwerte, was einer gewöhnlichen Differenzenbildung entspricht. Damit sind die bekannten Verfahren bei vorhandenen Oberschwingungen der Ausgangsgrößen äußerst ungenau. Frequenzen oberhalb der Netzfrequenz $\Omega_N$ werden überhaupt nicht bzw. nur sehr schlecht gedämpft, so daß eventuell vorhandene Oberschwingungen starke Verfälschungen verursachen können.

Außerdem muß beachtet werden, daß durch die Digitalisierung der zeitkontinuierlichen Größen Digitalisierungsrauschen entsteht, was ebenfalls zu einem Fehler führt, wenn die eingesetzten Filter höhere Frequenzen nicht ausreichend unterdrücken.

Im folgenden wird nun die Filterrealisierung und die Parameterermittlung nach dem erfindungsgemäßen Verfahren für den besonders vorteilhaften Fall beschrieben, daß die zu prüfende Anordnung eine Hochspannungsübertragungsleitung ist.

Die Gewichtsfaktoren $h_i$, $g_i$ der zu realisierenden FIR-Filter werden vorteilhafter Weise folgendermaßen gewählt:

$$h_0 = h_n = 0$$
$$h_1 = h_{n-1} = 1$$
$$h_2 = h_{n-2} = 2$$
$$\cdots$$
$$h_{n/2-1} = h_{n/2+1} = n/2 - 1$$

und

$$g_0 \quad = - \; g_n \quad = 1/2$$
$$g_1 \quad = - \; g_{n-1} = 1$$
$$g_2 \quad = - \; g_{n-2} = 1$$
$$\ldots$$
$$g_{n/2-1} = - \; g_{n/2+1} = 1$$

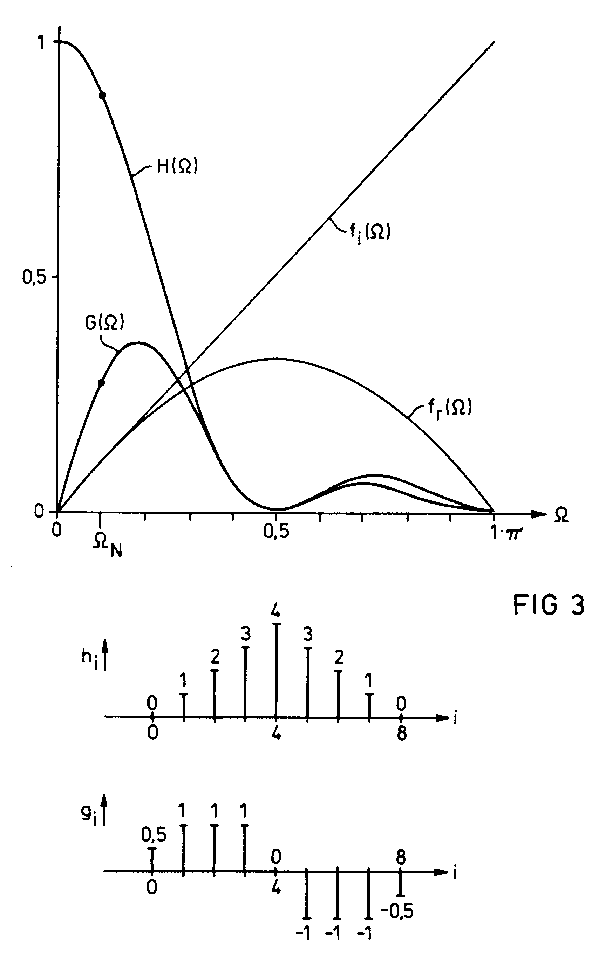

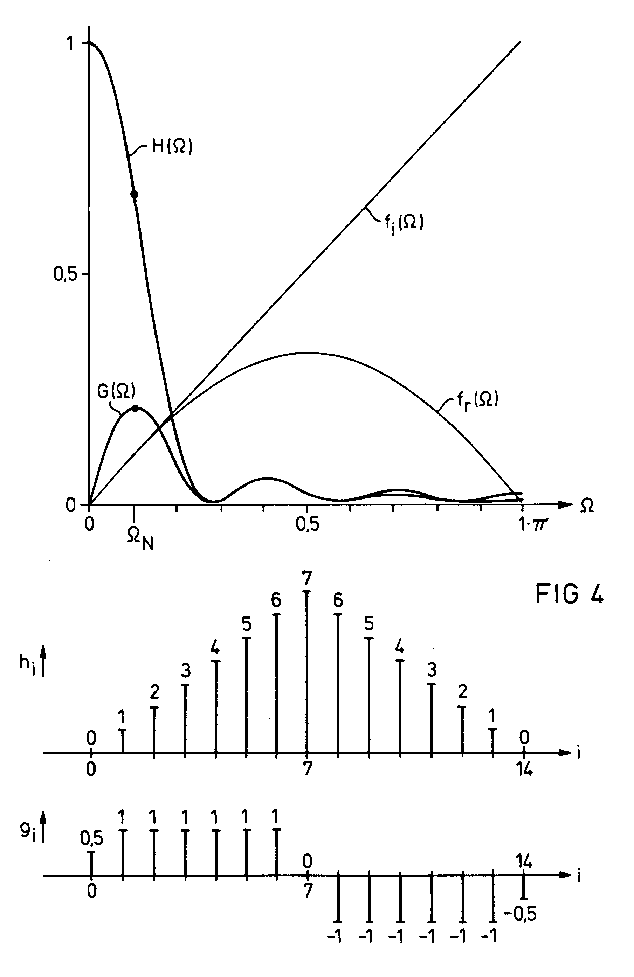

Darüber hinaus ist für $h_{n/2} = n/2$ und für $g_{n/2} = 0$ anzusetzen. Eine Darstellung dieser gewählten Gewichtsfaktoren ist den Figuren 3 und 4 zu entnehmen.

Nachdem die Gewichtsfaktoren $h_i$ , $g_i$ in Form einfach zu erzeugender und zu verarbeitender Zahlen gewählt worden sind, können die Amplitudengänge gemäß Gleichungen (6a) und (6c) berechnet werden. Daraus ergibt sich dann der Korrekturfaktor $k_c$ nach Gleichung (10) als $k_c = \sin \Omega_N$. Dieser Korrekturfaktor $k_c$ ist unabhängig von dem gewählten Zählergrad n, er hängt einzig von der Netzfrequenz $\Omega_N$ ab und ist somit für alle Zählergrade n konstant. Danach werden mit den gewählten Gewichtsfaktoren $h_i$ und $g_i$ und mit dem ermittelten Korrekturfaktor $k_c$ die Parameter a und b nach den Gleichungen (11), (12) für zwei Abtastwerte k und m, die günstigerweise 1/4 Netzperiode auseinanderliegen, berechnet. Bei einer Abtastung von beispielsweise 20 Abtastungen pro Periode bedeutet dies die Verwendung jedes fünften Abtastwertes zur Berechnung der Parameter.

Bei der Verwendung des erfindungsgemäßen Verfahrens zur Distanzmessung ist es vorteilhaft, zur schnellen und ausreichend genauen Ermittlung von Netzinduktivität $L_N$ und ohmschem Netzwiderstand $R_N$ einen Zählergrad von n = 8 zu wählen. In Fig. 3 sind für diesen Fall die Amplitudengänge und die Gewichtsfaktoren dargestellt. In der Darstellung kennzeichnet eine ideale Kurve $f_i$ (mit $f_i (\Omega) = G_i (\Omega) / H_i (\Omega) = \Omega$) die Realisierung einer idealen Filtereinheit, welche zu jeder Frequenz die Filterbedingung erfüllt. Man erkennt, daß eine reale Kurve $f_r$ (mit $f_r (\Omega) = G_c (\Omega) / H_c (\Omega)$) für die nach dem erfindungsgemäßen Verfahren realisierten FIR-Filter die Filterbedingung im Bereich der Netzfrequenz $\Omega_N$ erfüllt. Weiterhin sind in der Figur 3 die normierten Amplitudengänge H $(\Omega)$ und G $(\Omega)$ der realisierten FIR-Filter dargestellt. Es ist deutlich zu erkennen, daß im Bereich der Netzfrequenz $\Omega_N$ eine gute Übertragung erfolgt, während eine starke Dämpfung bei höheren Oberfrequenzen einsetzt. Bestimmte Frequenzen, z. B. unerwünschte Oberfrequenzen, werden fast völlig eliminiert.

Zur Ermittlung des Fehlerorts ist es vorteilhaft, den Zählergrad mit n = 14 anzusetzen. Die sich hieraus ergebenden Filterkennlinien sind der Figur 4 zu entnehmen. Auch hier ist anhand der Kurven $f_i$ und $f_r$ deutlich zu erkennen, daß die Kurve $f_r$ im Bereich der Netzfrequenz $\Omega_N$ aufgrund der vorgegebenen Gewichtsfaktoren mit der Kurve $f_i$ übereinstimmt. Gegebenenfalls auftretende Oberschwingungen werden in einem noch stärkeren Maße auch bei niedrigen Frequenzen gedämpft, als dies mit n = 8 (Fig. 3) der Fall ist. Die Ermittlung der Parameter dauert in diesem Fall zwar länger, weil ja eine größere Anzahl von Abtastwerten abzuarbeiten ist, sie wird aber auch entsprechend genauer, was für die Ermittlung des Fehlerortes wichtig ist.

Zusammenfassend gesagt, hat daher das erfindungsgemäße Verfahren zur Prüfung von durch Differentialgleichungen erster Ordnung beschreibbaren Anordnungen besondere Vorteile. Auf der einen Seite werden unerwünschte Oberschwingungen im Erregersignal, die das Ergebnis der zu ermittelnden Parameter verfälschen könnten, in starkem Maße gedämpft. Auf der anderen Seite ist das Verfahren so variabel, daß entsprechend den Anforderungen unterschiedliche Zählergrade n gewählt werden können, wobei die aufgrund der vorgegebenen Gewichtsfaktoren erforderliche Korrektur äußerst einfach durchzuführen ist in Form einer Multiplikation des Korrekturfaktors als konstante Zahl mit den ermittelten Parameter. Als weiterer Vorteil der Vorgabe gewählter Gewichtsfaktoren ist deren einfache Verarbeitung durch einfache elektronische Bauelemente zu sehen.

**Patentansprüche**

1. Verfahren zur Prüfung von Anordnungen, deren Betriebsverhalten durch lineare, zeitinvariante Differentialgleichungen erster Ordnung beschreibbar ist, bei dem

a) die Ausgangsgrößen (u,i) der jeweils zu prüfenden Anordnung während einer entsprechenden Eingangserregung der Anordnung gemessen werden,

b) die gemessenen Ausgangsgrößen (u,i) der zu prüfenden Anordnung in einer Filtereinheit (1) mit Einzelfiltern (3,5;6) eines ersten und eines zweiten Typs derart mit den zwei Filtertypen bewertet werden, daß an den Ausgängen der Einzelfilter (3,5;6) Signale entstehen, die durch die Bewertung der Ausgangsgrößen (u,i) mittels Einzelfilter (3,5) des ersten Typs und durch die Bewertung mindestens einer (i) der Ausgangsgrößen (u,i) mittels Einzelfilter (6) des zweiten Typs gebildet sind, wobei die Bewertung mittels des Einzelfilters (6) des zweiten Typs der ersten zeitlichen Ableitung der Ausgangsgröße (i) entspricht,

c) die in den Differentialgleichungen vorkommenden Parameter (a,b) der Anordnung aus den bewerteten Ausgangsgrößen in einer Recheneinheit ermittelt werden und

d) bei der Bewertung entstandene Fehler durch eine Fehlerkorrektur berücksichtigt werden,

**dadurch gekennzeichnet,** daß

e) die gemessenen Ausgangsgrößen (u, i) digitalisiert und in einer digitalen Filtereinheit (1) bewertet werden, die aus einer entsprechenden Anzahl von linearphasigen, nichtrekursiven Digitalfiltern (FIR-Filter) eines ersten Typs (3, 5) (mit den Gewichtsfaktoren $h_i$) und aus mindestens einem Digitalfilter eines zweiten Typs (6) (mit den Gewichtsfaktoren $g_i$) besteht,

f) die einzelnen Gewichtsfaktoren ($h_i$, $g_i$) der FIR-Filter (3, 5, 6) frei vorgegeben werden und

g) die Fehlerkorrektur mittels eines Korrekturfaktors ($k_c$) durchgeführt wird, der als Quotient aus den Amplitudengängen (H ($\Omega$), G ($\Omega$)) der FIR-Filter ersten und zweiten Typs (3, 5, 6) gebildet wird.

2. Verfahren nach Anspruch 1, **dadurch gekennzeichnet,** daß
   h) die Filtereinheit (1) und die Fehlerkorrektur in der Recheneinheit realisiert werden.

3. Verfahren nach Anspruch 1 oder 2, **dadurch gekennzeichnet,** daß
   i) das FIR-Filter ersten Typs (3, 5) durch ein symmetrisches Zählerpolynom (Gewichtsfaktorenverteilung $h_i = h_{n-i}$) mit geradem Zählergrad n und das FIR-Filter zweiten Typs (6) durch ein antisymmetrisches Zählerpolynom (Gewichtsfaktorenverteilung $g_i = - g_{n-i}$) mit geradem Zählergrad n beschrieben wird.

4. Verfahren nach Anspruch 1, **dadurch gekennzeichnet,** daß
   j) die Gewichtsfaktoren $h_i$ des FIR-Filters ersten Typs (3, 5) mit der Verteilung $h_i = h_{n-i}$ mit geradem Zählergrad n
   in der Form

$$
\begin{aligned}
h_0 &= h_n &&= 0 \\
h_1 &= h_{n-1} &&= 1 \\
h_2 &= h_{n-2} &&= 2 \\
&\cdots \\
h_{n/2-1} &= h_{n/2+1} &&= n/2 - 1
\end{aligned}
$$

vorgegeben werden und

k) die Gewichtsfaktoren $g_i$ des FIR-Filters zweiten Typs (6) mit der Verteilung $g_i = - g_{n-i}$ mit geradem Zählergrad n in der Form

$$
\begin{aligned}
g_0 &= - g_n &&= 1/2 \\
g_1 &= - g_{n-1} &&= 1 \\
g_2 &= - g_{n-2} &&= 1 \\
&\cdots \\
g_{n/2-1} &= - g_{n/2+1} &&= 1
\end{aligned}
$$

vorgegeben werden.

5. Verfahren nach Anspruch 4, **dadurch gekennzeichnet,** daß

l) bei einer zu prüfenden Hochspannungsübertragungsleitung zur Distanzmessung der Zählergrad mit n = 8 gewählt wird und

m) zur Fehlerortsbestimmung der Zählergrad mit n = 14 gewählt wird.

## Claims

1.  Method for testing arrangements, the operational performance of which can be described by means of linear, time-invariant differential equations of the first order, in which

    a) the output variables (u,i) of the arrangement to be tested in each case are measured during a corresponding input excitation of the arrangement;

    b) the measured output variables (u,i) of the arrangement to be tested are evaluated in a filter unit (1) with individual filters (3,5;6) of a first and a second type in such a way with the two filter types that signals result at the outputs of the individual filters (3,5;6), which signals are formed by the evaluation of the output variables (u,i) by means of individual filters (3,5) of the first type and by the evaluation of at least one (i) of the output variables (u,i) by means of individual filters (6) of the second type, the evaluation by means of the individual filter (6) of the second type corresponding to the first derivative with respect to time of the output variable (i);

    c) the parameters (a,b) of the arrangement which occur in the differential equations are determined from the evaluated output variables in an arithmetic unit; and

    d) errors which arose in the evaluation are taken into consideration by means of an error correction; characterised in that

    e) the measured output variables (u,i) are digitized and are evaluated in a digital filter unit (1) which consists of a corresponding number of linear-phase non-recursive digital filters (FIR-filters) of a first type (3,5) (with the weighting coefficients $h_i$) and of at least one digital filter of a second type (6) (with the weighting coefficients $g_i$);

    f) the individual weighting coefficients ($h_i$, $g_i$) of the FIR-filters (3, 5, 6) are preset freely; and

    g) the error correction is carried out by means of a correction factor ($k_c$) which is formed as a quotient from the amplitude responses ($H(\Omega)$, $G(\Omega)$) of the FIR-filters of the first and second type (3, 5, 6).

2.  Method according to claim 1, characterised in that

    h) the filter unit (1) and the error correction are realized in the arithmetic unit.

3.  Method according to claim 1 or 2, characterised in that

    i) the FIR-filter of the first type (3, 5) is described by a symmetrical counter polynomial (weighting coefficient distribution $h_i = h_{n-i}$) with even degree n and the FIR-filter of the second type (6) is described by an antisymmetrical counter polynomial (weighting coefficient distribution $g_i = - g_{n-i}$) with even degree n.

4.  Method according to claim 1, characterised in that

    j) the weighting coefficients $h_i$ of the FIR-filter of the first type (3, 5) are preset with the distribution $h_i = h_{n-i}$ with even degree n in the form

$$
\begin{aligned}
h_0 &= h_n &&= 0 \\
h_1 &= h_{n-1} &&= 1 \\
h_2 &= h_{n-2} &&= 2 \\
&\cdots \\
h_{n/2-1} &= h_{n/2+1} &&= n/2 - 1
\end{aligned}
$$

and

k) the weighting coefficients $g_i$ of the FIR-filter of the second type (6) are preset with the distribution $g_i = - g_{n-i}$ with even degree n in the form

$$g_0 \qquad = - g_n \qquad = 1/2$$
$$g_1 \qquad = - g_{n-1} \quad = 1$$
$$g_2 \qquad = - g_{n-2} \quad = 1$$
$$\cdots$$
$$g_{n/2-1} \qquad = - g_{n/2+1} = 1.$$

**5.** Method according to claim 4, characterised in that

l) in the case of a high voltage transmission line which is to be tested, for the purpose of distance measurement the degree is selected with n = 8; and

m) for the purpose of error location determination the degree is selected with n = 14.

**Revendications**

**1.** Procédé pour tester des dispositifs, dont le comportement en fonctionnement peut être représenté par des équations différentielles linéaires du premier ordre, invariantes dans le temps, et selon lequel

a) on mesure les grandeurs de sortie (u,i) du dispositif devant être testé, pendant une excitation d'entrée correspondante du dispositif,

b) des grandeurs de sortie mesurées (u,i) du dispositif devant être testé sont évaluées dans une unité de filtre (1) comportant des filtres individuels (3,5,6) d'un premier et d'un second type, avec deux types de filtres, de telle sorte qu'aux sorties des filtres individuels (3,5,6) apparaissent des signaux qui sont formés au moyen de l'évaluation des grandeurs de sortie (u,i) à l'aide de filtres individuels (3) du premier type et au moyen de l'évaluation d'au moins l'une (i) des grandeurs de sortie (u,i) à l'aide de filtres individuels (6) du second type, l'évaluation à l'aide du filtre individuel (6) du second type correspondant à la dérivée première dans le temps de la grandeur de sortie (i),

c) les paramètres (a,b) du dispositif, qui interviennent dans les équations différentielles, sont déterminés dans une unité de calcul à partir des grandeurs de sortie évaluées, et

d) des erreurs apparaissant lors de l'évaluation sont prises en compte au moyen d'une correction d'erreur,

caractérisé par le fait que

e) les grandeurs de sortie mesurées (u,i) sont numérisées et évaluées dans une unité de filtre numérique (1), qui est constituée par un nombre correspondant de filtres numériques non récursifs et à phase linéaire (filtres FIR) d'un premier type (3,5) (comportant les facteurs de pondération $h_i$) et par au moins un filtre numérique d'un second type (6) (comportant les facteurs de pondération $g_i$),

f) les différentes facteurs de pondération ($h_i,g_i$) des filtres FIR (3,5,6) sont prédéterminés de façon libre, et

g) la correction d'erreur est exécutée au moyen d'un facteur de correction ($k_c$), qui est formé en tant que quotient des caractéristiques d'amplitude ($H(\Omega)$, $G(\Omega)$) des filtres FIR des premier et second types (3,5,6).

**2.** Procédé suivant la revendication 1, caractérisé par le fait que

h) l'unité de filtre (1) et la correction d'erreur sont réalisées dans l'unité de calcul.

**3.** Procédé suivant la revendication 1 ou 2, caractérisé par le fait que

i) le filtre FIR du premier type (3,5) est décrit par un polynôme numérateur symétrique (répartition des facteurs de pondération $h_i = h_{n-i}$) possédant un degré de numérateur n pair et le filtre FIR du second type (6) est décrit par un polynôme numérateur antisymétrique (répartition des facteurs de pondération $g_i = -g_{n-i}$) ayant un degré de numérateur n pair.

**4.** Procédé suivant la revendication 1, caractérisé par le fait que

j) les facteurs de pondération $h_i$ du filtre FIR du premier type (3,5) possédant la répartition $h_i = h_{n-i}$ avec un degré de numérateur n pair sont prédéterminés sous la forme

$$h_0 \qquad = h_h \qquad = 0$$
$$h_1 \qquad = h_{n-1} \qquad = 1$$
$$h_2 \qquad = h_{n-2} \qquad = 2$$
$$\ldots$$
$$h_{n/2-1} \qquad = h_{n/2+1} \qquad = n/2 - 1$$

et

k) les facteurs de pondération $g_i$ du filtre FIR du second type (6) possédant la distribution $g_i = -g_{n-i}$ avec un degré de numérateur n pair, sont prédéterminés sous la forme

$$g_0 \qquad = - g_n \qquad = 1/2$$
$$g_1 \qquad = - g_{n-1} \qquad = 1$$
$$g_2 \qquad = - g_{n-2} \qquad = 1$$
$$\ldots$$
$$g_{n/2-1} \qquad = - g_{n/2+1} \qquad = 1$$

**5.** Procédé suivant la revendication 4, caractérisé par le fait que

l) on choisit le degré de numérateur n = 8 dans le cas d'une ligne de transmission à haute tension devant être testée, pour la mesure de distance, et

m) on choisit le degré de numérateur n = 14 pour la localisation de défauts.

FIG 1A

FIG 1B

FIG 2

**EP 0 284 546 B1**

FIG 3

16

FIG 4